# EUROPEAN PATENT SPECIFICATION

(11) **EP 0 407 088 B1**
(45) Date of publication and mention of the grant of the patent: **06.05.1998**
(21) Application number: 90307023.3
(22) Date of filing: 27.06.1990
(51) Int. Cl.: H01L 31/20, C23C 16/22, C23C 14/12

(54) **Method of forming an amorphous semiconductor film**
Verfahren zur Herstellung einer amorphen Halbleiterschicht
Méthode de production d'un film semiconducteur amorphe

(30) Priority: 28.06.1989 JP 163710/89; 29.06.1989 JP 165402/89; 29.06.1989 JP 165403/89; 02.08.1989 JP 199258/89; 02.08.1989 JP 199259/89; 02.08.1989 JP 199260/89; 03.08.1989 JP 200234/89; 23.01.1990 JP 11803/90
(43) Date of publication of application: 09.01.1991
(73) Proprietor: Mitsui Chemicals, Inc., Tokyo 100-6070 (JP)
(72) Inventor: Miyachi, Kenji, Yokohama-shi, Kanagawa-ken (JP); Fukuda, Nobuhiro, Yokohama-shi, Kanagawa-ken (JP); Ashida, Yoshinori, Yokohama-shi, Kanagawa-ken (JP); Koyama, Masato, Kamakura-shi, Kanagawa-ken (JP)
(74) Representative: Stuart, Ian Alexander

(56) References cited:
- DE-A- 3 208 086
- JOURNAL OF APPLIED PHYSICS vol. 65, no. 6, 15 March 1989, pages 2439 - 2444, New York, US; A. ASANO et al.: "Preparation of highly photoconductive hydrogenated amorphous silicon carbide films with a multiplasme-zone apparatus"
- THIN SOLID FILMS vol. 171, no. 1, 1 April 1989, pages 217 - 233, Lausanne, CH; M. PINARBASI et al.: "Hydrogenated amorphous silicon films deposited by reactive sputtering: The electronic properties hydrogen bonding and microstructure"
- PATENT ABSTRACTS OF JAPAN vol. 12, no.217 (E-624), 21 June 1988; & JP-A-63 014 420 (HITACHI) 21.01.1988
- SOLAR & WIND TECHNOLOGY vol. 6, no. 3, 1989, pages 241 - 246, Den Haag, NL; Y. HAMAKAWA: "Physics and Technologies of Efficiency Improvements for Amorphous Silicon Solar Cells"
- THIN SOLID FILMS vol. 147, no. 2, 2 March 1987, pages 213 - 222, Lausanne, CH; K.P. CHICK et al.: "A comparative study of the properties of evaporated a-Si films before and after hydrogenation"
- SOLAR CELLS vol. 24, nos. 3/4, August 1988, pages 249 - 256, Lausanne, CH; Y.S. TSUO et al.: "Ion-beam hydrogenation of amorphous silicon"
- SOLAR ENERGY MATERIALS vol. 17, no. 4, June 1988, pages 237 - 245, Amsterdam, NL; G. GANGULY et al.: "A study of the optoelectronic and structural properties of glow-discharge-deposited amorphous silicon thin films"
- PHYSICAL REVIEW, B. CONDENSED MATTER vol. 31, no. 8, 15 April 1985, pages 5311 - 5321, New York, US; M. JANAI et al.: "Properties of fluorinated glow-discharge amorphous silicon"
- SOLAR CELLS vol. 24, nos. 3/4, August 1988, pages 237 - 248, Lausanne, CH; R.S. CRANDALL: "Fundamental studies of amorphous silicon materials at the solar energy research institute"

## Description

This invention relates to a technology of improving the quality of an amorphous conductor film constituting a solar cell.

Amorphous solar cells have already gained widespread practical acceptance as an energy-supplying source having a small output for driving electronic portable calculators or watches. However, for large outputs of 0.1 W or higher for solar light power generation applications, amorphous semiconductor films having satisfactory performance and stability have not been developed as an energy-supply source. Much work is being done for increased performance. This problem is essentiai to an amorphous silicon hydride film, formed by such film-forming methods as a plasma CVD method, a light CVD method, or a heat CVD method, and a further improvement in performance was considered to be difficult.

For a solution to this problem, Japanese Laid-Open Patent Publication No. 14420/1988 discloses that the formation of a film and its plasma treatment with hydrogen or a halogenating substance is repeated. The improvement achieved by this technique has not been satisfactory. The present inventors considered that the main cause of this problem is that a large amount of hydrogen is involved during film formation to form an amorphous silicon hydride. Furthermore, the present inventors considered the fact that most of semiconductor films constituting amorphous solar cells now in practical use are formed by the plasma CVD method, and searched for a method which enables the plasma CVD method to be used in addition to other methods in a film-forming step.

As a result, the present inventors found that a semiconductor having a narrow optical band gap with a small amount of combined hydrogen can be obtained by repeating a step of improving the properties of the film, for example, comprising forming a semiconductor film having a specified amount of combined hydrogen to a specified thickness, and exposing the film to a discharging atmosphere containing a reactive gas, and that the electro-optical properties of the resulting semiconductor film are much better than a conventional Si film.

DE-A-3208086 discloses a method of forming an amorphous silicon film in which a silicon is evaporated in a vacuum and deposited in a substrate. An arc discharge generates atomic hydrogen which is directed onto the silicon film. DE-A-3208086 also discloses that the atomic hydrogen may be replaced by atomic oxygen or fluorine, possibly with a dopant.

An article entitled "Preparation of highly photoconductive hydrogenated amorphous silicon carbide films with a multiplasma-zone apparatus" by A. Asano et al published in Journal of Applied Physics Vol. 65, No. 6, 15 March 1989 pages 2439-2444 discloses the production of amorphous silicon carbide films, in which monolayer deposition and hydrogen passivation were carried out alternately. The article discloses layer thicknesses of 0.3, 0.6 and 0.9mm.

An article entitled "Hydrogenated amorphous silicon films deposited by reactive sputtering: the electronic properties, hydrogen bonding and microstructure", by M. Pinarbasi et al published in Thin Solid Films, Vol. 171, No. 1, 1 April 1989, pages 217 to 233 discloses hydrogenated amorphous silicon films with a hydrogen concentration of less than 20%.

An article entitled "Fundamental Studies of Amorphous Silicon Materials at the Solar Energy Research Institute" by R.S. Crandall in the Solar Cells Vol. 24, Nos. 3/4, August 1988 pages 237 to 248 discloses hydrogenated amorphous silicon film containing fluorine.

According to the present invention there is provided a method of forming an amorphous semiconductor film which comprises the sequential steps of (a) forming a halogen-containing silicon-type semiconductor film to a thickness of 0.1 to 10mm and (b) de-halogenating-hydrogenating the formed film; the sequence steps (a) and (b) being repeated multiple times.

The film-forming step of the invention is not particularly limited. Specifically, it may be film formation by a physical deposition method such as vacuum evaporation, sputtering, or ion plating, a chemical vapour deposition method such as light CVD or plasma CVD.

In the process of this invention, the film-forming step and the de-halogenating-hydrogenating step are repeated. In the film-forming step, it is preferable to form a semiconductor film containing not more than 20 atomic percent of combined hydrogen. Other film-forming conditions do not essentially impair the effects of this invention.

The effective method of physically forming a film will be described below.

The starting material (target) for film formation in this invention includes silicon and compounds or alloys of elements such as silicon carbide, silicon nitride, and silicon-germanium alloy (or composite powder), or silicon-tin alloy (or composite powder). Essentially hydrogen-free substances can be effectively used. The film-forming conditions are not to be particularly limited except that the amount of hydrogen combined is smaller than the specified in this invention. The amount of combined hydrogen in the semiconductor film is not more than 20 atomic percent, preferably not more than 10 atomic percent but at least 0 atomic percent. If these conditions are fulfilled, the film-formation may be effected in an atmosphere of an inert gas, hydrogen, a hydrocarbon, fluorine or oxygen gas. The specific conditions are that the flow rate of the gas is 1 to 100 sccm, and the reaction pressure is 0.001 mtorr to 100 mtorr (1 mtorr = 0.133 Pa). Depending upon the film-forming speed, such film-forming conditions as the flow rate, the pressure or electric power may be properly selected. The film-forming temperature (substrate temperature) is basically not restricted. The temperature is preferably set to conform to the modifying step. Specifically, it is chosen from the range of not more than 500 °C and at least 150 °C.

Specific effective examples are shown below when the film-formation is carried out by the CVD method.

The starting gas for film formation in this invention is a silane compound represented by general formula SiₙH₂ₙ₊₂ (n is a natural number), such as monosilane, disilane, trisilane or tetrasilane, or silane fluoride, organosilane, or a hydrocarbon. A gas such as hydrogen, fluorine, chlorine, helium, argon, neon or nitrogen may be introduced together with the starting gas. When such a gas as hydrogen is used, it is effective to use it in an amount of 0.01 to 100 % (volume ratio based on the starting gas). Its amount is selected by considering the speed of film formation or the properties of the film such as the amount of hydrogen combined. In the case of using the chemical vapor deposition method, the film-forming conditions are not particularly limited except that as in the case of physical film-forming method, the amount of hydrogen combined is decreased to below a specific amount. The film forming conditions are selected so that the amount of hydrogen combined in the semiconductor film in this invention is not more than 20 atomic percent, preferably not more than 10 atomic percent. If ordinary conditions are selected, a semiconductor film having not more than 20 atomic percent of hydrogen is obtained. If desired, if the temperature is elevated within the above range, the amount of hydrogen can be made smaller. If this amount exceeds 20 atomic percent, the effect to be exhibited is very low, and the object of this invention cannot be achieved.

Specific conditions for this purpose will be shown below. In the case of light CVD, the starting gas is decomposed by using a low-pressure mercury lamp, or a deuterium lamp or a rare gas lamp yielding ultraviolet light having a wavelength of not more than 350 nm. The conditions for film formation include a gas flow rate of 1 to 100 sccm, a reaction pressure of 15 mtorr to atmospheric pressure, and a substrate temperature of 200 to 600 °C.

When the thermal resistance of the substrate plate, the film-forming time that can be calculated from the speed of film formation and the plasma treating temperature are considered, the preferred temperature of the substrate is usually chosen from the range of 300 to 500 °C.

The plasma CVD is carried out under the following specific conditions.

The method of discharge that can be effectively used may be, for example, high frequency discharge, direct-current discharge, microwave discharge, or ECR discharge. The flow rate of the starting gas is 1 to 900 sccm, the reaction pressure is 0.001 mtorr to atmospheric pressure, and the electric power is in the range of 1 mW/cm² to 10 W/cm². These film-forming conditions are sufficient for the process, but may be changed as required depending upon the speed of film formation and the method of discharging. The temperature of the substrate is 200 to 600 °C, preferably 300 to 500 °C. The temperature is preferably higher within this range.

The substrate on which to form the semiconductor films is not essentially limited except that it can withstand the process temperature of the invention. Transparent materials such as soda lime glass, borosilicate glass or quartz glass, or metallic materials, ceramic materials and thermally stable polymeric materials may be used as the substrate. Of course, a substrate having an electrode formed therein as used in solar cells or sensors may effectively be used in this invention.

Embodiments of the present invention will now be described in detail, by way of example, with reference to the accompanying drawings, in which:

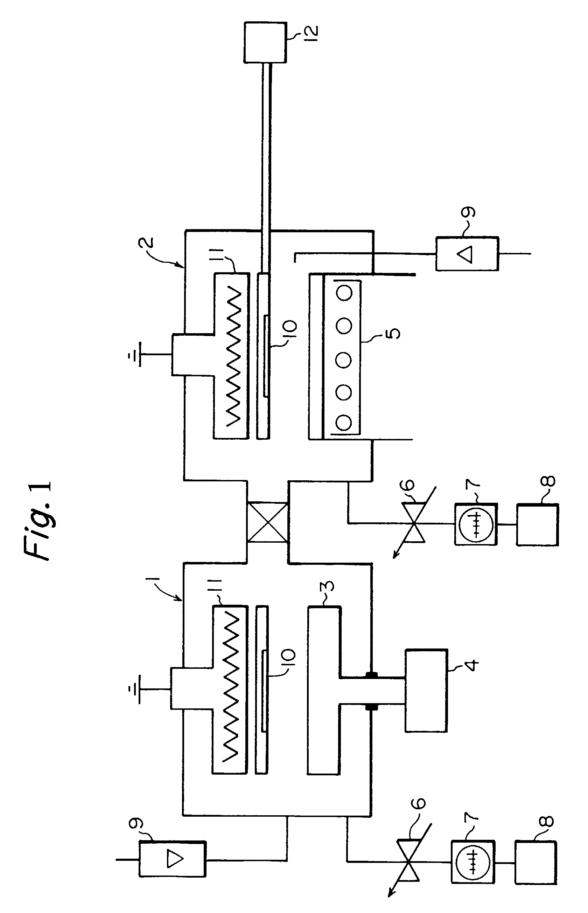

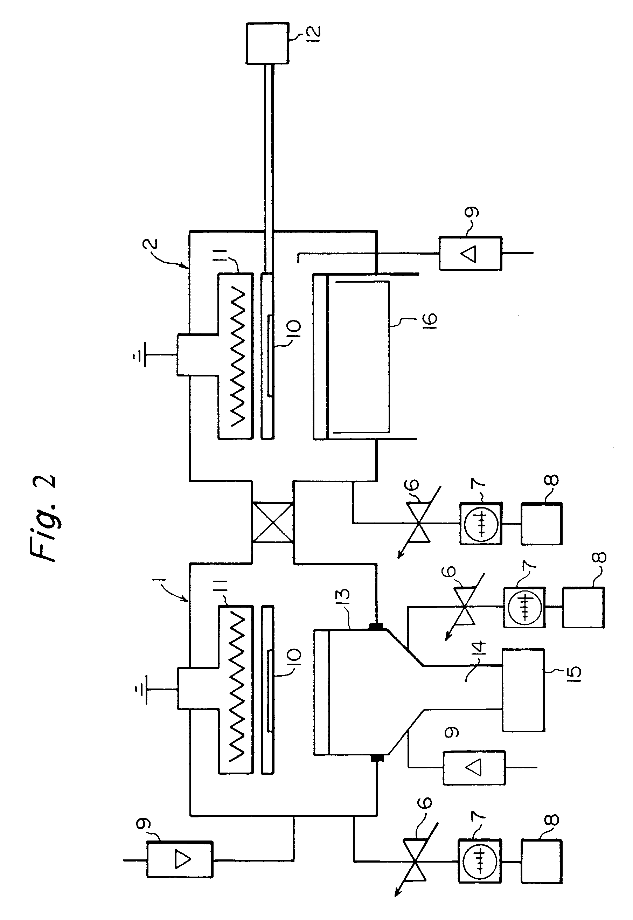

Figures 1 and 2 are schematic views showing examples of a device for forming a film in accordance with this invention. In the drawings, 1 represents a film-forming chamber; 2 represents a de-halogenating-hydrogenating chamber; 3 represents a high frequency electrode; 4 represents a pressure control valve; 7 represents a turbo-molecular pump; 8 represents a rotary pump; 9 represents a gas flow meter; 10 represents a substrate; 11 represents a substrate heater; 12 represents a substrate conveying mechanism; 13 represents an ultraviolet light generating device; 14 represents a wave guide tube; 15 represents a microwave power supply; and 16 represents a xenon flash lamp.

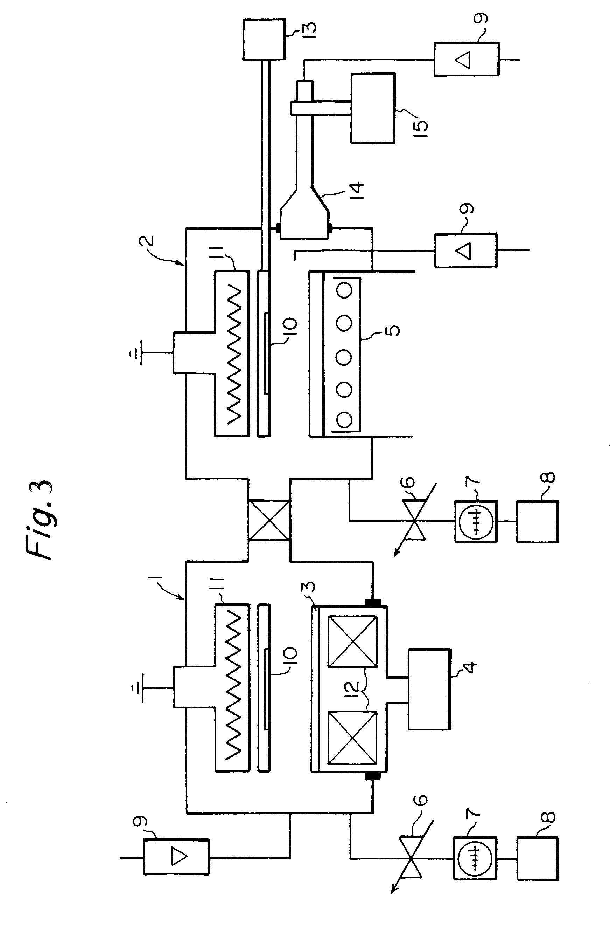

Figures 3 to 5 are schematic views showing examples of a film producing device for practicing the present invention. In the drawings, 1 represents a film-forming chamber; 2 represents a de-halogenating-hydrogenating chamber; 3 represents an Si target; 4 represents a high frequency power supply; 5 represents a low pressure mercury lamp; 5 represents a pressure control valve; 7 represents a turbo-molecular pump; 8 represents a rotary pump; 9 represents a gas flow meter; 10 represents a substrate; 11 represents a substrate heater; 12 represents a magnet; 13 represents a substrate conveying mechanism; 14 represents a halogen atom generating device; 15 represents a microwave power supply; 16 represents a mercury reservoir; 17 represents a xenon flash lamp; 18 represents an ECR discharge mechanism; and 19 represents a high frequency electrode.

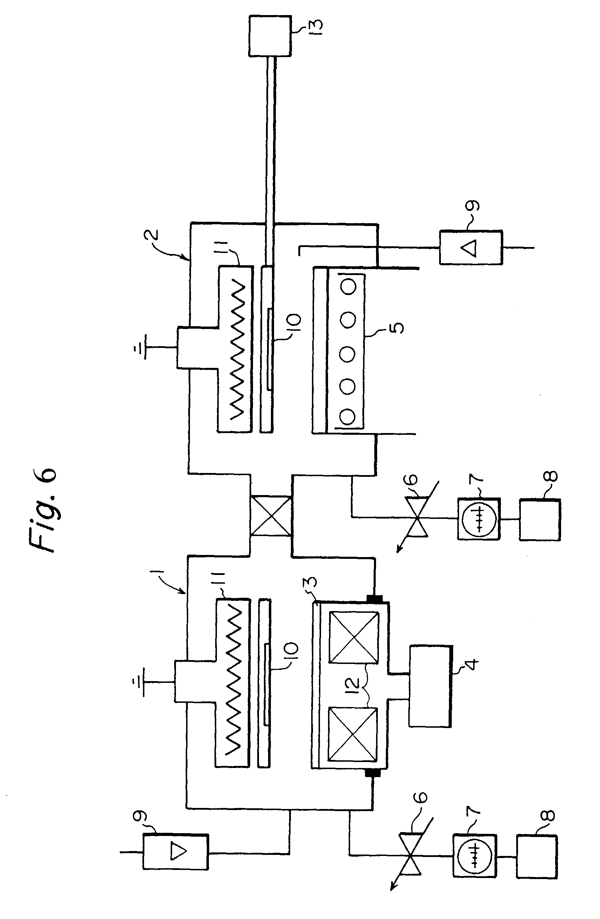

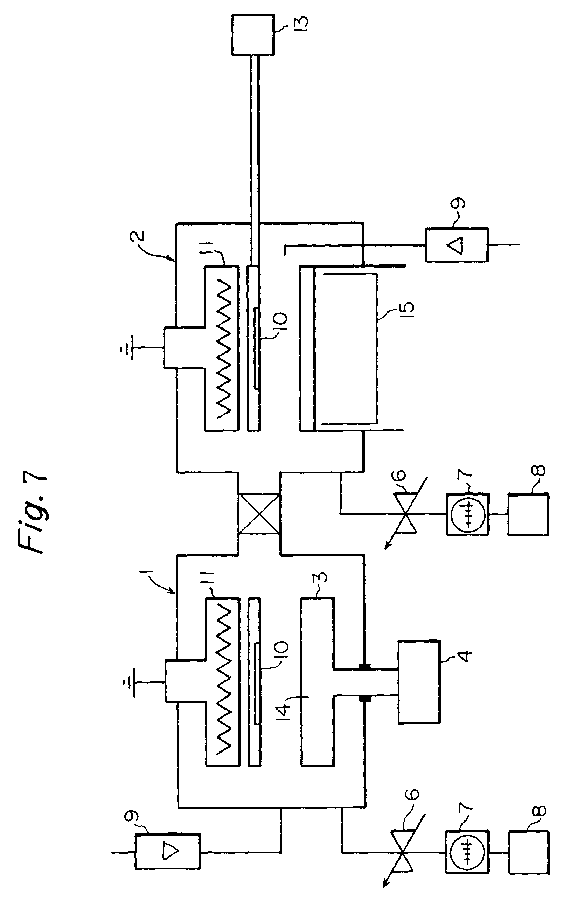

Figures 6 and 7 are schematic views showing one example of a film producing device for practicing the present invention. In the drawings, 1 represents a film-forming chamber (by sputtering); 2 represents a de-halogenating-hydrogenating chamber; 3 represents an Si target; 4 represents a high frequency power suppply; 5 represents an ultraviolet lamp; 6 represents a pressure control valve; 7 represents a turbo-molecular pump; 8 represents a rotary pump; 9 represents a gas flow meter; 10 represents a substrate; 11 represents a substrate heater; 12 represents a magnet; 13 represents a substrate conveying mechanism; 14 represents a high frequency power supply; and 15 represents a xenon flash lamp.

According to the invention, a silicon semiconductor film is modified by de-halogenated-hydrogenation.

In this case, the silicon semiconductor film is a halogenated silicon semiconductor film, and the de-halogenated-hydrogenation can be carried out by contacting the halogenated silicon semiconductor film with a silicon hydride gas. On the other hand, if the silicon semiconductor film is a silicon hydride semiconductor film, the de-halogenated-hydrogenation of this film may be carried out by irradiating light onto the semiconductor film in an atmosphere of a silicon hydride gas or a halogenate. First, a method involving using a silicon hydride gas will be described.

The halogenated silicon semiconductor film may be formed, specifically by a physical film-forming method such as vacuum vapor deposition, sputtering or ion plating or by a chemical vapor phase film-forming (CVD) method such as light CVD and plasma CVD. The de-halogenated-hydrogenation step is a step whereby silicon hydride is introduced into a film-forming surface which is coated with halogen atoms, and heat, light or ionization is applied to induce de-halogenation-hydrogenation and silicon atoms are bonded to the film. The halogenated simiconductor film of the invention may contain hydrogen.

In the present invention, it is essential to repeat the film-forming step and the de-halogenation-hydrogenation step. Preferably, the thickess of the semiconductor film formed by every repetition of these steps is limited to not more than 100 Å but at least 1 Å. Other film-forming conditions do not particularly impair the effect of the invention.

An effective physical film-forming method will be described below.

In the physical film forming method, an element, compound or alloy, for example, silicon, silicon carbide, silicon nitride, a silicon-germanium alloy (or a compound powder), or a silicon-tin alloy (or compound powder) may be used effectively as a starting material (target) for film formation. A reactive film-forming method carried out in an atmosphere of fluorine or chlorine is convenient. After film formation, the film may be converted to a silicon halide by treatment with a halogen element. Preferably, a film-forming temperature of at least 500 °C may be used under conditions where the surface of the film is coated with halogen atoms. Film formation in an atmosphere of an inert gas, a hydrocarbon or an oxygen gas does not impair the objects of the invention. Specific film-forming conditions are a gas flow rate of 1 to 100 sccm, and a reaction pressure of 0.001 mtorr to 10 mtorr. Depending upon the film-forming speed, film-forming conditions such as the flow rate, the pressure and the power may be properly selected. The film-forming temperature (substrate temperature) is not basically restricted. The temperature is preferably preset by bringing it into conformity to the de-halogenation-hydrogenation reaction. Specifically, a temperature of not more than 500 °C may be specifically selected.

A specific example of the effective CVD method will be shown below.

As a starting gas for film formation, usable are a mixed gas of a silane compound of the formula SiₙH₂ₙ₊₂ such as monosilane, disilane, trisilane or tetrasilane and a halogen gas such as chlorine or fluorine; a halogenated silane such as monofluorosilane, difluorosilane, trifluorosilane, tetrafluorosilane, monochlorosilane, dichlorosilane or trichlorosilane; a gaseous mixrture of hydrogen and such a halogenated silane; and gaseous mixture of these with silicon carbide, hydrocarbons, etc. Hydrogen, helium, argon, neon, nitrogen, etc. may be introduced together with the starting gas. These subsidiary gases may be used effectively in a volume ratio of 0.01 to 100 % based on the volume of the starting gas. The proportion of the gas may be properly selected by considering the film-forming speed or the film properties such as the amount of hydrogen.

The film-forming conditions are not limited in particularly, as in the case of the physical film-forming method. Specific conditions will be described below.

In the case of the light CVD method, the starting gas is decomposed and formed into a film by using ultraviolet sources having a wavelengh of not more than 350 nm such as a low pressure mercury lamp, a deuterium lamp or a rare gas lamp. The preferred condition for film formation are a gas flow rate of 1 to 100 sccm, a reaction pressure of 15 mtorr to atmospheric pressure, and a substrate temperature of room temperuture to 600 °C. The preferred substrate temperature, when considered from the viewpoint of the film-forming time and the temperature of the de-halogenation-hydrogenation step that can be conceived from the thermal resistance and the film-forming speed of the substrate, is 300 to 500 °C.

In the case of the plasma CVD, high-frequency discharge, direct-current discharge, microwave discharge or ECR discharge may be effectively used as a method of discharging. Sufficient conditions are a starting gas flow rate of 1 to 900 sccm, a reaction pressure of 0.001 mtorr to atmospheric pressure, and a power of 1 mW/cm² to 10 W/cm². These film-forming conditions may be properly changed according to the film-forming speed and the method of discharging. The substrate temperature is preferably room temperature to 600 °C, and more preferably 300 to 500 °C.

In the present invention, the de-halogenated-hydrogenation step of the formed semiconductor film is performed by introducing a silane compound into the de-halogenated-hydrogenation chamber, and applying heat, light or ionization to it. When heat is used, the temperature of the substrate is 400 to 600 °C, preferably 400 to 500 °C. In the case of light irradiation or ionic irradiation, the temperature of the substrate is from room temperature to 600 °C, preferably 200 to 450 °C, which can be lowered as compared with the case of using only heat.

A silicon hydride such as monosilane, disilane, or trisilane can be effectively used as the silane compound.

De-halogenation-hydrogenation by light irradiation is especially preferred. To induce this de-halogenation-hydrogenation reaction effectively, it is preferred to make the pressure in the accumulation chamber low. The de-halogenation-hydrogenation reaction is pedrformed by irradiating light to the surface of the silicon halide in an atmosphere of silicon hydride. The temperature of the substrate is from room temperature to 600 °C, preferably froom 200 to 450 °C. The reaction pressure is 1 mtorr to 1 torr, more preferably 10 mtorr to 100 mtorr. To perform the de-halogenation-hydrogenation reaction effectively, the light to be fed is preferably is light to be supplied from a low-pressure mercury lamp, a rare gas discharge lamp, an ultraviolet laser, a deuterium lamp, an Xe pulse lamp, a visible light laser or a carbon dioxide laser.

The de-halogenation-hydrogenation reaction in this invention is especially an effective reaction under low pressures, and light other than ultraviolet light can be effectively utilized. It should be understood therefore that it differs in technical scope from the light CVD in the prior art. The irradiation time may be suitably selected according to the rate of forming the film.

By one film-forming step, a film having a thickness of not more than 100 Å and at least 1 Å is formed. The film thickness below 100 Å is controlled by the film-forming time. Since the film-forming rate is about 0.1 to 30 Å/sec., if the film thickness exceeds 100 Å, the effect of the de-halogenation-hydrogenation step to be subsequently carried out decreases. If the film thickness by one film-formation is made very thin, for example, as less than 1 Å, the effect of the invention is not impaired, but the repetition times must be increased to several thousand. The time required for each cycle is not particularly limited, but preferably within 1000 seconds. The time required for shifting from the film-forming step to the de-halogenation-hydrogenation step, and the time required for shifting from the de-halogenation-hydrogenation step to the film-forming time are preferably as short as possible. The film thickness is not limited, but is about 10 Å to 10 micrometers. This time depends upon the shape and size of the device and the evacuating system, but specifically can be shortened to within 30 seconds.

In a preferred embodiment of this invention, the silicon film is formed by growing the silicon film by 1 to several atomic layers by repeating the de-halogenation-hydrogenation step by coating of halogen on the surface of the film, de-halogenation-hydrogenation of it with silicon hydride, coating of halogen on the film surface and the de-halogenation-hydrogenation by silicon hydride. The resulting silicon film is very few in microvoids and has a high density.

The substrate on which the semiconductor film is formed is not limited except that it should withstand to the processing temperature of this invention. It may be formed of a light-pervious material such as blue plate glass, borosilicate glass or quartz glass, metals, ceramics and thermally stable polymeric materials may be used as a substrate. A substrate on which an electrode is formed, which can be used in a solar cell or a sensor, may also be effectively used in this invention.

Now, the matter-mentioned method involving using a silicon halide gas will be described. Specifically, a silicon hydride semiconductor film is formed by a physical film-forming method such as vacuum evaporation, sputtering or ion plating, or a chemical vapor deposition method (CVD such as light CVD method, or plasma CVD method). The de-halogenated-hydrogenation step is the step whereby the surface of the film formed is coated with hydrogen, a silicon halide is introduced, and by applying heat, light, ionization is applied, the de-halogenation-hydrogenation is allowed to proceed to bond silicon atoms to the film.

It is essential in this invention to repeat the film-forming step and the de-halogenated-hydrogenation step. By one repetition, the thickness of the semiconductor film is increased to not more than 100 Å and at least 1 Å. Other film-forming conditions do not particularly impair the effects of the invention.

An effective physical film-forming method will be described below.

As a starting material (target) for physical film formation, an element, a compound or an alloy, for example, silicon, silicon carbide, silicon nitride, silicon-germanium alloy (or compound powder) or silicon-tin alloy (or a compound powder) may be used. A reactive film-forming method in a hydrogen atmosphere is convenient. After the film-formation, the film may be converted to a hydrogenated semiconductor film by treating it with hydrogen. Preferably, under such conditions that while the film surface is coated with hydrogen, a film forming temperature of not more than 500 °C may be employed. Film formation in an atmosphere of an inert gas, hydrogen, hydrocarbon, fluorine or oxygen gas does not impair the objects of this invention. Specific conditions include a gas flow rate of 1 to 100 sccm, a reaction pressure of 0.001 mtorr to 10 mtorr. According to the rate of film-formation, the film-forming conditions such as the flow rate, the pressure and the power may be properly selected. The film-forming temperature (base temperature) is not basically restricted. But preferably, the temperature is preset to bring it into conformity with the de-halogenated-hydrogenation step. Specifically, temperatures or 500 °C or below may be chosen.

A specific example of an effective CVD method will be illustrated below.

As a starting gas for film formation, a silane compound of general formula SiₙH₂ₙ₊₂ where n is a natural number such as monosilane, disilane, trisilane, or fluorosilane, silicon carbide, may be used singly or in combination. The starting gas may be introduced together with such gases as hydrogen, fluorine, chlorine, helium, argon, neon and nitrogen. When these gases are used, it is effective to use them in a volume ratio of 0.01 to 100 % based on the starting gas. The proportion of these gas may be properly selected in view of the film-forming temperature or the properties (such as the amount of hydrogen) of the film.

The film-forming conditions as in the method of physical film-forming method is not limited. Specific conditions will be described below. In the case of light CVD, the starting gas is decomposed by using ultraviolet light sources having a wavelength of not more than 350 nm, such as a low-presssure mercury lamp, a deuterium lamp or a rare gas lamp, and film formation is carried out. The film forming conditions include a gas flow rate of 1 to 100 sccm and a reaction pressure of 15 mtorr to atmospheric pressure. The preferred substrate temperature is room temperature to 600 °C. The preferred substrate temperature, in view of the film-forming rate and the temperature of the de-halogenated-hydrogenation step that can be considered from the heat resistance and film-forming rate of the substrate, is 300 to 500 °C.

In the case of plasma CVD, high-frequency discharge, microwave discharge and ECR discharge may be used as an effective method of discharging. Other conditions include a starting gas flow rate of 1 to 900 sccm, a reaction pressure of 0.001 mtorr to atmospheric pressure, and an electric power of 1 mW/cm² to 10 mW/cm². These film-forming conditions are properly changed according to the film-forming rate and the method of discharging. The substrate temperature is preferably room temperature to 600 °C, more preferably 300 to 500 °C.

In the present invention, the de-halogenated-hydrogenation step of the semiconductor film formed is performed by introducing a silicon halide into the de-halogenated-hydrogenating chamber, and applying heat, ligth or ionization. When heat is used, the substrate temperature is 400 to 600 °C, preferably 400 to 500 °C. In the case of light irradiation or ionizing irradiation, the substrate temperature is from room temperature to 600 °C, preferably 200 to 450 °C, which may be lower than in the case of using heat. To use heat, light and ionization in combination is a prefered means. To induce the de-halogenation-hydrogenation reaction with a good efficiency, the pressure of the de-halogenating-hydrogenating chamber is preferably made lower. It is in the range of 1 mtorr to 1 torr, more preferably 10 mtorr to 100 mtorr.

The conditions for performing de-halogenation-hydrogenation while light irradiation is being carried out are substantially the same as the above-mentioned method which is carried out in an atmosphere of silicon hydride.

Silicon halides used in the de-halogenation-hydrogenation step are compounds resulting from substituting the hydrogen of silicon hydride (abbreviated as silane) by halogen, and include, for example, halogenated silanes, halogenated disilanes, halogenated trisilane. The effective halogen atoms are fluorine, chlorine and bromine. Specific examples include monofluorosilane, difluorosilane, trifluorosilane, monochlorosilane, dichlorosilane, trichlorosilane, monofluorosilane, difluorodisilane, monochlorodisilane and dichlorodisilane.

By one film-forming step, a film having a thickness of nor more than 100 Å and at least 1 Å is formed. Thicknesses of 100 Å or below may be controlled by the film-forming time. Since the film-forming rate is about 0.1 to 30 Å/sec., film formation may be, for example, take a time of about 3 seconds to 1000 seconds. When the film thickness exceeds 100 Å, the de-halogenation-hydrogenation to be carried out next has a lowered effect. When a thickness for one film formation is very thin, for example less than 1 Å, the effect of the present invention is not impaired, but the repeating times should be increased to several thousand. The time required for one cycle is not a requirement which has to be limited particularly, but is preferably within 1000 seconds. The time required to shift from the film-forming step to the de-halogenation-hydrogenation and the time required for shifting from the dehalogenation step to the film-forming step are preferably as short as possible. This time depends upon the shape and size of the device and the vacuum evacuating system. Specifically, the time may be shortened to less than 30 seconds. The film-forming step and the de-halogenation-hydrogenation step may be carried out in the same reaction chamber, or in separate chambers. The effect of the invention is not impaired if they are carried out in either way. The film thickness is not particularly limited, usually is is about 10 Å to 10 micrometers.

In a preferred embodiment of this invention, by repeating hydrogen coating of the surface of the film, de-halogenation-hydrogenation by a silicon halide, and coating of hydrogen on the surface of the film formed and de-halogenation-hydrogenation with a silicon halide, a silicon film is formed by 1 to several atomic layer. The so obtained silicon film has very few microvoids and has a high density.

The substrate on which to form the semiconductor film is not limited except that is can withstand the processing temperature of this invention. It may be any of light-pervious materials such as blue plate glass, borosilicate glass or quartz glass, metals, ceramics or thermally stable polymeric materials. Substrates having electrodes formed thereon, which may be used in solar cells or sensors, may be effectively used in this invention.

### Example 1

The apparatus shown in Figure 1 was used. This apparatus consists of a film-forming chamber 1 and a de-halogenating-hydrogenating chamber 2. The film-forming chamber has a discharging device for accumulating a halogenated semiconductor film. These two chambers were connected by a conveying device 12. The substrate continuously moved to and from the two chambers and was repeatedly subjected to film-formation and treatment. As a starting material, a gaseous mixture of trichlorosilane and hydrogen was introduced through a flow meter 9 in an amount of 10 sccm. The temperature of the substrate 10 was preset at 300 °C which was the temperature in the next de-halogenation-hydrogenation. At a pressure of 0.08 torr in the reaction chamber, a high-frequency electric power of 10 W was applied to form an Si film to a thickness of about 40 Å on the substrate. After film-formation, the substrate was transferred to the de-halogenated-hydrogenating chamber within 60 seconds. Disilane was introduced into the de-halogenating-hydrogenating chamber. While ultraviolet light was irradiated by the ultraviolet lamp 5 at a reaction pressure of not more than 0.1 torr, the hydrochlorinated Si film was exposed to the ultraviolet light for 30 seconds. The substrate was returned to the film-forming chamber. The film-forming step-de-halogenation-hydrogenation step were repeated under the same conditions. By 100 repetitions of these steps, a film having a thickness of 4000 Å was obtained. A quartz glass substrate and a single crystal Si substrate were used as the substrate. The optical properties of the Si film formed on the quartz substrate were measured. A metallic electrode was formed no part of it, and its electrical properties were meaaured. The sample formed on the single crystal Si substrate was measured by infrared absorption spectroscopy to estimate the amount of bound hydrogen. This amount of bound hydrogen was further confirmed by secondary ion mass spectrometory (SIMS).

The resulting Si film had the following properties. Optical band gap 1.65 eV; under an irradiation of a pseudo-solar light (AM-1.5) in a dose of 100 mW/cm², conductivity (photo conductivity) 1 x 10⁻⁴ S/m; dark conductivity 8 x 10⁻¹¹ S/cm; activation energy 0.8 eV; and the amount of hydrogen bound 5 at%.

To examine the light stability of this Si film, a pseudo-solar light (AM-1.5) was continuously irradiated in a dose of 100 mW/cm² for 20 hours, and a change in photo conductivity was observed. The change in photo conductivity 20 hours later as against the photo conductivity in the initial stage was about 7 %. It was found that the film had very high stability.

The characteristic feature of the present invention, as can be seen from this Example, is that in spite of the low amount of hydrogen, the film had high light sensitivity, and its light deterioration ratio was small.

### Example 2

In Example 1, the film thickness and the de-halogenation-hydrogenation time were changed respectively to about 3 Å and 6 seconds. The film thickness was changed by changing the film-forming time. Since in Example 1 it was found that the film-forming speed by sputtering was about 1 Å/sec., in this Example the film-forming time or one film formation was adjusted to 3 seconds. By repeating the film-forming step and the de-halogenation-hydrogenation step 1350 times, a film having a thickness of 4000 Å was obtained.

The resulting film had the properties shown below when they were measured.

Optical band gap 1.60 eV; under irradiation of a pseudo-solar light (AM-1.5) in a dose of 100 mW/cm², conductivity (photo conductivity) 3 x 10⁻⁴ S/cm; dark conductivity 4 x 10⁻¹¹ S/cm; activation energy 0.81 eV; and the amount of bound hydrogen 3 at%.

To examine the light stability of the Si film, a pseudo-solar light (AM-1.5) was continuously irradiated for 20 hours in a dose of 100 mW/cm² for 20 hours, and the change in photo conductivity was observed. The change in photo conductivity 20 hours after the initial photo conductivity was not more than 5 %, and it was found that the film had very high stability.

The present Example was very effective although the number of film formation-de-halogenation-hydrogenation steps repeated was as high as 13.5 times that in Example 1.

### Example 3

In Example 3, monosilane was used as the silicon hydride, and ultraviolet light in vacuum was irradiated. The same measurement as in Example 15 was made to obtain the following results. Optical band gap 1.76 eV; uner irradiation of a pseudo-solar light (AM-1.5) at 100 mW/cm², conductivity (photo conductivity) 4 x 10⁻⁵ S/cm; dark conductivity 5 x 10⁻¹⁰ S/cm; activation energy 0.88 eV; and the amount of bound hydrogen 10 at%.

A pseudo-solar light (AM-1.5) was irradiated continuously for 20 hours at a dose of 100 mM/cm², and a change in photo conductivity was observed. The change of photo conductivity 20 hours later as against the photo conductivity in the initial stage was about 8 %, it was found that the film had very high stability.

### Example 4

The apparatus shown in Figure 2 including a film-forming chamber provided with a discharge tube capable of irradiation of ultraviolet light was used. A mixture of trifluorosilane and disilane was used as a starting material. At a pressure of 0.15 torr and a substrate temperature of 300 °C, ultraviolet light having a wavelength of 253 nm was irradiated by an ultraviolet light generating device. The de-halogenation-hydrogenation step was carried out in the same way as in Example 15 except that in Example 1, a xenon pulse light was irradiated from a xenon flash lamp 16.

The properties of the film obtained by this method were as follows. Under irradiation of a pseudo-solar light (AM-1.5) at a dose of 100 mW/cm², conductivity (photo conductivity) 1 x 10⁻⁴ S/cm; dark conductivity 1 x 10⁻¹⁰ S/cm; optical band gap 1.65 e; activation energy 0.83 eV; and the amount of bound hydrogen 5 at%.

To examine the light stability of this Si film, a pseudo-solar light (AM-1.5) was continuously irradiated for 20 hours at a dose of 100 mW/cm² for 20 hours, and a change in photo conductivity was observed. A change in photo conductivity 20 hours later as against the photo conductivity in the initial stage was about 7 %. It was found that the film had very high stability.

### Comparative Example 1

In Example 1, an Si halide film was formed, and then without going through a de-halogenated-hydrogenation step, the film was grown to a thickness of 4000 Å. The properties of the film obtained by this method were: Photo conductivity 6 x 10⁻⁶ S/cm; dark conductivity 6 x 10 ⁻⁹ S/cm; and the amount of bound hydrogen 11 at%. The properties of this film were extremely lower than the properties of the film shown in Example 1.

### Comparative Example 2

In Example 1 an Si film was formed to a thickness of 4000 Å, and then the de-halogenation-hydrogenation step set in and de-halogenation-hydrogenation was carried out for a time of 1200 seconds. The properties of the film obtained by this method were photo conductivity 2 x 10⁻⁵ S/cm; dark conductivity 1 x 10⁻⁹ S/cm; and the amount of bound hydrogen 11 at%. These film properties were lower than those shown in Example 1, and were the same as those of an Si film obtained by a conventional glow discharge method or a light CVD method. When the photo stability of this film was measured, the change in photo conductivity after 20 hours was 90 %, which was about the same degree as a conventional Si film.

### Example 5

The apparatus shown in Figure 3 was used. This apparatus was comprised of an accumulation chamber 1 and a de-halogenating-hydrogenating chamber 2 equipped with a halogen atom generating means, and the accumulation chamber 1 had a sputtering device for accumulating a semiconductor film. These two chambers were connected by a conveying device 13. The substrate continuously moved between the two chambers. Thus, steps of accumulation, halogenation and de-halogenated-hydrogenation can be repeated. In view of the accumulation chamber, etc., the sputtering was in accordance with a high-frequency magnetron sputtering method. As a starting material, a high-purity silicon target 3 was set at the cathode, and a mixture of argon and chlorine (10 sccm) was introduced through a flow meter 9. The temperature of the substrate was set at 300 °C which was the temperature of the next de-halogenated-hydrogenation step. At a pressure of 0.6 mtorr in the accumulating chamber, a high-frequency power (100 W) was applied to perform sputtering for several seconds and thereby several atomic layers of Si were accumulated. Then, the substrate was transferred to the de-halogenation-hydrogenation chamber 2, and halogen atoms were introduced to perform halogenation of the surface. Disilane was introduced, and under a pressure of 0.01 torr, ultraviolet light was irradiated from a lower pressure mercury lamp. The Si halide film was exposed to the ultraviolet for 10 seconds. Again in the film-forming chamber 1, sputtering was carried out for several seconds to accumulate several atomic layers of Si. In the de-halogenating-hydrogenating chamber 2, halogen atoms were introduced to perform halogenation of the surface. Then, disilane was introduced to perform de-halogenation-hydrogenation. Thus, the accumulation step-de-halogenation-hydrogenation step were repeated under the same conditions to give a film having a thickness of about 4000 Å. A quartz substrate and a single crystal Si substrate were used as the substrate. The optical properties of the Si film formed on the quartz substrate were measured, and a metallic electrode was formed on part of it, and its electrical properties were measured. The film formed on the single crystal Si substrate was analyzed by infrared absorption spectrum measurement, and the amount of bound hydrogen was calculated. This amount of bound hydrogen was further confirmed by secondary ion mass spectrometory (SIMS).

The properties of the obtained Si film were as follows: Optical band gap 1.68 eV; under irradiaton of a pseudo-solar light (AM-1.5) at a dose of 100 mW/cm², 9 x 10⁻⁵ S/cm; dark conductivity 7 x 10⁻¹¹ S/cm; activation energy 0.84 eV; and the amount of bound hydrogen 6 at%.

To examine the light stability of this Si film, a pseudo-solar light (AM-1.5) was continuously irradiated for 20 hours at a dose of 100 mW/cm² for 20 hours, and a change in photo conductivity was observed. A change in photo conductivity 20 hours later as against the photo conductivity in the initial stage was about 8 %. It was found that the film had very high stability.

It is clearly seen from the results of this Example that the present invention is characterized by the fact that in spite of its low amount of hydrogen, the resulting film had high light sensitivity and a small light deterioration ratio.

### Example 6

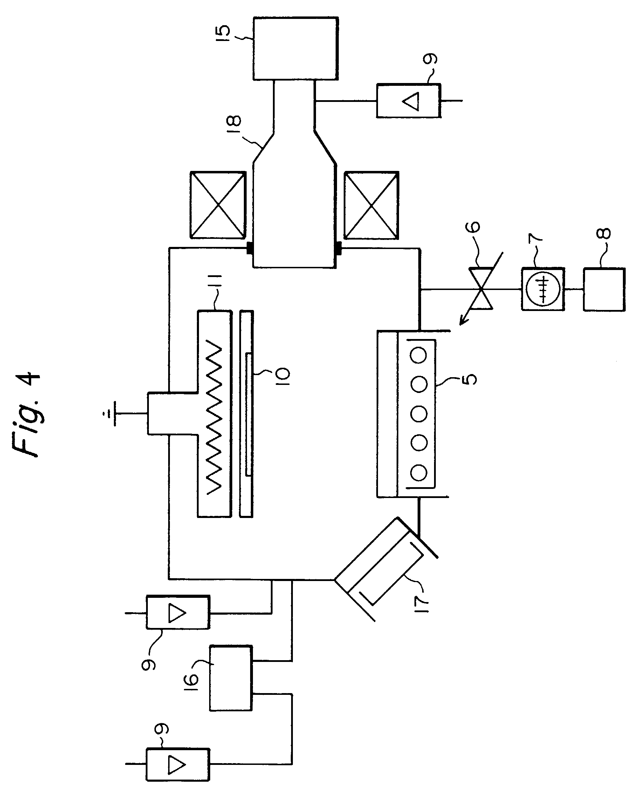

The apparatus shown in Figure 4 was used. In this apparatus, one chamber was used both as an accumulation chamber and a de-halogenating-hydrogenating chamber. A substrate 10 was set up, and then monochlorosilane and monosilane were introduced. By light CVD with mercury sensitization, silicon chloride was formed. The supply of a mercury vapor was stopped, and by electron cyclotron resonance (ECR) discharge, chlorine atoms were generated and supplied to the surface of silicon chloride. Then, disilane was introduced under a pressure of 10 mtorr, a de-halogenation-hydrogenation was carried out under irde-halogenation-hydrogenation was carried out under irradiation of a low-pressure mercury lamp 5. By repeating the supply of chlorine atoms, the introduction disilane and the de-halogenation-hydrogenation reaction, a film having a thickness of about 4000 Å was obtained. The film was evaluated by the same method as in Example 5. The results were optical band gap 1.65 eV; under a pseudo-solar light (AM-1.5) at a dose of of 100 mW/cm², conductivity (photo conductivity) 2 x 10⁻⁴ S/cm; dark conductivity 6 x 10⁻¹¹ S/cm; activation energy 0.82 eV; and the amount of bound hydrogen 4 at%.

To examine the light stability of this Si film, a pseudo-solar light (AM-1.5) was continuously irradiated at a dose of 100 mW/cm² for 20 hours, and a change in photo conductivity was observed. A change in photo conductivity 20 hours later as against the photo conductivity in the initial stage was not more than 5 %. It was found that the film had very high stability.

### Example 7

In Example 6, disilane was used instead of monosilane used in Example 6 as a mixture with monochlorosilane. By a direct light CVD without using a mercury vapor, silicon chloride was formed. Disilane was used as silicon hydride, and the de-halogenation-hydrogenation was performed by irradiating an Xe pulse light by means of a xenon flash lamp 17. The same measurement as in Example 19 was performed. The results were optical band gap 1.78 eV; an irradiation of a pseudo-solar light (AM-1.5) in a dose of 100 mW/cm², conductivity (photo conductivity) 3 x 10⁻⁵ S/cm; dark conductivity 4 x10⁻¹⁰ S/cm; activation energy 0.88 eV; and the amount of bound hydrogen 10 at%.

To examine the light stability of this Si film, a pseudo-solar light (AM-1.5) was continuously irradiated for 20 hours at a dose of 100 mW/cm² for 20 hours, and a change in photo conductivity was observed. A change in photo conductivity 20 hours later as against the photo conductivity in the initial stage was about 9 %. It was found that the film had very high stability.

### Example 8

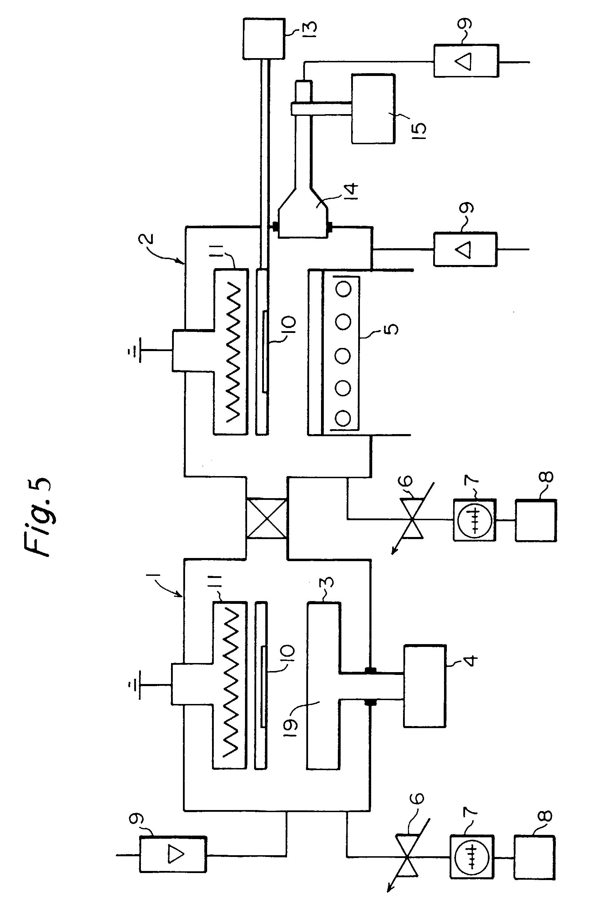

An experiment was conducted by using the apparatus shown in Figure 5. Instead of sputtering, a film-forming chamber 1 including a film-forming chamber 1 was used. A mixture of hexafluorodisilane and disilane was used as a starting material, and at a pressure of 0.05 torr, a substrate temperature of 300 °C and an RF discharge power of 20 W a film having several atomic layers was formed for each film-forming step. The de-halogenated-hydrogenation step was performed as in Example 5.

The film obtained by this method had the following properties. Under irradiation of pseudo-solar light (AM-1.5) at a dose of 100 mW/cm², conductivity (photo conductivity) 6 x 10⁻⁵ S/cm; dark conductivity 9 x 10⁻¹¹ S/cm; optical band gap 1.70 e; activation energy 0.84 eV; and the amount of hydrogen bound 7 at%.

To examine the light stability of this Si film, a pseudo-solar light (AM-1.5) was continuously irradiated for 20 hours at a dose of 100 mW/cm² for 20 hours, and a change in photo conductivity was observed. A change in photo conductivity 20 hours later as against the photo conductivity in the initial stage was about 8 %. It was found that the film had very high stability.

### Example 9

An experiment was conducted by using the apparatus shown in Figure 6. This apparatus consisted of a film-forming chamber 1 and a de-halogenating-hydrogenating chamber 2. The film-forming chamber 1 had a sputtering device for accumulating a hydride semiconductor film. These two chambers were connected by a conveying device 13, and the substrate can continuously move between these chambers to repeat film-formation and treatment. Sputtering was carried out by a high-frequency magnetron sputtering method by considering the rate of film formation. As a starting material, a high-purity silicon target 3 was set at the cathode, and a gaseous mixture of argon and hydrogen was introduced at as rate of 10 sccm through a flow meter. The substrate was set at a temperature of 300 °C as the temperature of the next de-halogenation-hydrogenation. At a pressrue of 0.6 mtorr in the film-forming chamber, a high-frequency power of 100 W was applied to form an Si film having a thickness of about 40 Å on the substrate. Within 60 seconds after film formation, the substrate was transferred to the de-halogenated-hydrogenating chamber. In the de-halogenated-hydrogenating chamber, monochlorosilane was introduced, and while ultraviolet light was irradiated under a pressure of 0.01 torr, the Si hydrate film was exposed to the irradiation of ultraviolet light for 30 seconds. Again, the substrate was returned to the film-forming chamber, and the film-forming step and the de-halogenated-hydrogenation step were repeated under the same conditions. By repeating them 100 times, a film having a thickness of about 4000 Å was as the substrate, a quartz glass substrate and a single crystal Si substrate were used. The optical properties of the Si film formed on the quartz plate were measured, and a metallic electrode was formed on part of it, and its electrical properties were measured. The sample formed on the single crystal Si substrate was measured by infrared absorption spectrum to estimate the amount of bound hydrogen. This amount of bound hydrogen was further confirmed by secondary ion mass spectrometory (SIMS).

The properties of the resulting Si film were as follows: Optical band gap 1.68 eV; under irradiation of a pseudo-solar light (AM-1.5) at a dose of 100 mW/cm², conductivity (photo conductivity) 9 x 10⁻⁵ S/cm; dark conductivity 7 x 10⁻¹¹ S/cm; activation energy 0.84 eV: and the amount of bound hydrogen 6 at%.

To examine the photo stability of this Si film, a pseudo-solar light (AM-1.5) was continuously irradiated for 20 hours at a dose of 100 mW/cm² for 20 hours, and a change in photo conductivity was observed. A change in photo conductivity 20 hours later as against the photo conductivity in the initial stage was about 8 %. It was found that the film had very high stability.

It is clearly seen from the results of this Example that the present invention is characterized by the fact that in spite of its low amount of hydrogen, the resulting film had high light sensitivity and a small light deterioration ratio.

### Example 10

In Example 9, the film thickness and the de-halogenation-hydrogenation time were respectively changed to about 3 Å and 6 seconds. The thickness of the film was changed to film-forming time. Since in Example 23 it was found that the rate of film formation by sputtering was about 1 Å/sec., in the present Example, the time for one film-formation was adjusted to 3 second. By repeating the film-forming step and the de-halogenation-hydrogenation step 1350 times, a film having a thickness of about 4000 Å was obtained. The same measurement as in Example 9 was performed, and the following results were obtained. Optical band gap 1.65 eV; under an irradiation of a pseudo-solar light (AM-1.5) at a dose of 100 mW/cm², conductivity (photo conductivity) 2 x 10⁻⁴ S/cm; dark conductivity 6 x 10⁻¹¹ S/cm; activation energy 0.82 eV; and the amount of bound hydrogen 4 at%.

To examine the light stability of the Si film, a pseudo-solar light (AM-1.5) was irradiated at a dose of 100 mW/cm² for 20 hours continuously, a change in photo conductivity was observed. A change in photo conductivity 20 hours later as against the initial stage photo conductivity was not more than 5 %, and it was found that the film had very high stability.

In this Example, the number of repeating times of film-formation and de-halogenation-hydrogenation was more than 13.5 times that in Example 9, but the operations in this Examples were very effectrive.

### Example 11

In Example 9, monofluorosilane was used as the silicon halide. The same measurement as in Example 9 was performed, and the following results were obtained. Optical band gap 1.78 eV; under an irradiation of a pseudo-solar light (AM-1.5) at a dose of 100 mW/cm², conductivity (photo conductivity) 3x10⁻⁵ S/cm; dark conductivity 4 x 10⁻¹⁰ S/cm; activation energy 0.88 eV; and the amount of bound hydrogen 10 at%.

To examine the light stability of this Si film, a pseudo-solar light (AM-1.5) was continuously irradiated for 20 hours at a dose of 100 mW/cm² for 20 hours, and a change in photo conductivity was observed. A change in photo conductivity 20 hours later as against the photo conductivity in the initial stage was about 9 %. It was found that the film had very high stability.

### Example 12

An experiment was conducted by using the apparatus shown in Figure 7. Instead of performing sputtering, a CVD film-forming method was performed by using a film-forming chamber having a discharge electrode. Disilane was used as a starting material, and at a pressure of 0.05 torr, a substrate temperature of 300 °C and a RF discharge power of 20 W, a film having a thickness of 100 Å was formed in one film-forming step. The de-halogenation-hydrogenation step was performed as in Example 9 except that a xenon pulse light was irradiated from a xenon flash lamp 15.

The properties of the film obtained as above were as follows: under an irradiation of a pseudo-solar light (AM-1.5) at a dose of 100 mM/cm², conductivity (photo conductivity) 8 x 10⁻⁹ S/cm; dark conductivity 9 x 10⁻¹¹ S/cm; optical band gap 1.70 e; activation energy 0.84 eV; and the amount bound hydrogen 7 at%.

To examine the light stability of this Si film, a pseudo-solar light (AM-1.5) was continuously irradiated for 20 hours at a dose of 100 mW/cm² for 20 hours, and a change in photo conductivity was observed. A change in photo conductivity 20 hours later as against the photo conductivity in the initial stage was about 8 %. It was found that the film had very high stability.

### Comparative Example 3

In Example 9, the Si film was formed to a thickness of 200 Å which exceeds 100 Å prescribed in this invention. Then a de-halogenation-hydrogenation step set in, and was carried out for 60 seconds. By 20 repetitions, a film having a thickness of 4000 Å was formed. The properties of the film obtained by this method had a photo conductivity of 2 x 10⁻⁵ S/cm, a dark conductivity of 1 x 10⁻⁹ S/cm and a bound hydrogen amount of 11 at%. The properties of this film were lower than those of the film shown in Example 9, and were the same as an Si film obtained by a conventional glow discharge method or light CVD method. When the light stability of this film was measured, the change in photo conductivity was about 90 % as in a conventional Si film.

### Example 13

The apparatus shown in Figure 3 was used. It was comprised of an accumulation chamber (film-forming chamber) 1 and a de-halogenating-hydrogenating chamber 2 equipped with a hydrogen atom generating means. The accumulation chamber has a sputtering device for accumulating a semiconductor film. These two chambers were connected by a conveyor device 13. The substrate 10 moved between two layers continuously, and steps of accumulation, hydration reaction and de-halogenation-hydrogenation could be repeated. The sputtering was in accordance with a high frequency magnetron sputtering method by considering the accumulation speed, for example. As a starting material, a high-purity silicon target 3 was set at the cathode, and a gaseous mixture of argon and hydrogen was introduced in an amount of 100 sccm through a flow meter 9. The substrate temperature was adjusted to 300 °C which was the temperature of the next de-halogenation-hydrogenation step. Under a pressure of 0.6 mtorr in the accumulation chamber, a high frequency power of 100 W was applied to perform sputtering for several seconds to accumulate several atomic layers of Si. Then, the substrate was transferred to the de-halogenation-hydrogenation chamber, hydrogen atoms were introduced from the hydrogen atom generating device to hydrogenate the surface. Monochlorosilane was introduced, and while ultraviolet light was irradiated under a pressure of 0.01 torr, the Si hydride film was exposed for 10 seconds to ultraviolet irradiation. Again in the film-forming chamber, several atomic layers of Si were piled by sputtering for several seconds. In the de-halogenating-hydrogenating chamber 2, hydrogen atoms were introduced to perform hydration of the surface. Then, monochlorosilane was introduced, and de-halogenated-hydrogenation was performed. Thus, the accumulation step-de-halogenation-hydrogenation step were repeated under the same conditions to give a film having a thickness of about 400 Å. As the substrate, a quartz glass substrate and a single crystal Si substrate were used. The optical properties of the Si film formed on the quartz glass substrate were measured. A metallic electrode was formed on part of the film and its electrical properties were measured. The sample formed on the single crystal Si substrate was used to estimate the amount of a bound hydrogen by measurement of infrared absorption spectrum. The amount of bound hydrogen was again confirmed by secondary ion mass spectrometory (SIMS).

The properties of the resulting Si film were as follows: Optical band gap 1.66 eV; under irradiation of a pseudo-solar light (AM-1.5) in a dose of 100 mW/cm², conductivity (photo conductivity) 1 x 10⁻⁴ S/cm; dark conductivity 5 x 10⁻¹¹ S/cm; activation energy 0.82 eV; and the amount of boud hydrogen 5 at%.

To examine the light stability of the Si film, a pseudo-solar light (AM-1.5) was irradiated continuously in a dose of 100 mW/cm², and a change in light conductivity was observed. The change of photo conductivity 20 hours later as against the photo conductivity in the initial stage was about 7 %. It was found that the film had very high stability.

As is clear from the results of this Example, the characteristic feature of the invention is that the film obtained had high light sensitivity in spite of a small amount of hydrogen, and had a small light deterioration ratio.

### Example 14

An experiment was conducted by using the apparatus shown in Figure 4. In this apparatus, one chamber was used both as an accumulation chamber and a de-halogenated-hydrogenating chamber. After a substrate 10 was set up, monosilane was introduced. Silicon hydride was formed by light CVD with mercury sensitization. The supply of a mercury vapor was stopped, by an electron cyclotron resonance (ECR) discharging mechanism 18, hydrogen atoms were generated and fed onto silicon hydride. Then, monochlorosilane was introduced and at a pressure of 10 mtorr, de-halogenation-hydrogenation was carried out under an irradiation of a low-pressure mercury lamp 5. The feeding of hydrogen atoms, the introduction of monochlorosilane and the de-halogenation-hydrogenation reaction were repeated to obtain a film having a thickness of 400 Å. The film was evaluated by the same method as in Example 13. The results were optical band gap 1.63 eV; under an irradiation of a pseudo-solar light (AM-1.5) at a dose of 100 mW/cm², conductivity (photo conductivity) 3 x 10⁻⁴ S/cm; dark conductivity 4 x 10⁻¹¹ S/cm; activation energy 0.80 eV; and the amount of bound hydrogen 3 at%.

To examine the light stability of the Si film, a pseudo-solar light (AM-1.5) was irradiated continuously in a dose of 100 mW/cm², and a change in photo conductivity was observed. The change of photo conductivity 20 hours later as against the photo conductivity in the initial stage was about 5 % or less. It was found that the film has very high stability.

### Example 15

In Example 14, disilane was used instead of monosilane. Silicon hydride was formed by direct light CVD without using a mercury vapor. Monofluorosilane was used as the silicon halide, and the de-halogenation-hydrogenation was carried out by irradiating Xe pulse light from a xenon flash lamp 17. By making the same measurement as in Example 13, the following results were obtained. Optical band gap 1.76 eV; under irradiation of a pseudo-solar light (AM-1.5) in a dose of 100 mW/cm, conductivity (photo conductivity) 3 x 10⁻⁵ S/cm; dark conductivity 2 x 10⁻¹⁰ S/cm; activation energy 0.86 eV; and the amount of bound hydrogen 9 at%.

To examine the light stability of the Si film, a pseudo-solar light (AM-1.5) was irradiated continuously in a dose of 100 mW/cm², and a change in photo conductivity was observed. The change of photo conductivity 20 hours later as against the photo conductivity in the initial stage was about 8 % or less. It was found that the film has very high stability.

### Example 15

An experiment was conducted using the apparatus shown in Figure 5. Instead of performing sputtering, a film-forming chamber 1 equipped with a discharge electrode was used. Disilane was used as a starting material, and at a pressure of 0.05 torr, a substrate temperature of 300 °C and a discharge power of 20 W, a film having a thickness of 100 Å was formed in each film-forming step. The de-halogenated-hydrogenation step was carried out in the same way as in Example 13.

The film obtained by this method had the following properties: under an irradiation of a pseudo-solar light (AM-1.5) in a dose of 100 mW/cm², conductivity (photo conductivity) 9 x 10⁻⁵ S/cm; dark conductivity 8 x 10⁻¹¹ S/cm; optical band gap 1.68 e; activation energy 0.83 eV; and the amount of bound hydrogen 6 at%.

To examine trhe light stability of the Si film, a pseudo-solar light (AM-1.5) was irradiated continuously in a dose of 100 mW/cm², and a change in photo conductivity was observed. The change of photo conductivity 20 hours later as against the photo conductivity in the initial stage was abour 8 % or less. It was found that the film had very high stability.

## Claims

1. A method of forming an amorphous semiconductor film which comprises the sequential steps of (a) forming a halogen-containing silicon-type semiconductor film to a thickness of 0.1 to 10nm and (b) de-halogenating-hydrogenating the formed film; the sequence steps (a) and (b) being repeated multiple times.

2. A method of claim 1 in which the halogen-containing silicon-type semiconductor film is halogenated amorphous silicon semiconductor, and de-halogenation -hydrogenation is carried out by contacting the halogenated amorphous silicon semiconductor film with silane gas.

3. A method of claim 2 in which the de-halogenation-hydrogenation is carried out under irradiation with light.

## Patentansprüche

1. Verfahren zum Ausbilden eines amorphen Halbleiterfilms, umfassend die aufeinanderfolgenden Schritte des (a) Ausbildens eines halogenhältigen Siliziumhalbleiter-Films mit einer Dicke von 0,1 bis 10 nm und (b) des Dehalogenisierens-Hydrierens des gebildeten Films; wobei die aufeinanderfolgenden Schritte (a) und (b) mehrmals wiederholt werden.

2. Verfahren nach Anspruch 1, bei dem der halogenhältige Siliziumhalbleiter-Film ein halogenierter amorpher Siliziumhalbleiter ist und die Dehalogenierung-Hydrierung durchgeführt wird, indem der halogenierte amorphe Siliziumhalbleiter-Film mit Silangas in Kontakt gebracht wird.

3. Verfahren nach Anspruch 2, bei dem die Dehalogenierung-Hydrierung unter Bestrahlung mit Licht durchgeführt wird.

## Revendications

1. Méthode de formation d'un film semi-conducteur amorphe qui comprend les étapes séquentielles de (a) former un film semi-conducteur du type silicium contenant un halogène sur une épaisseur de 0,1 à 10 nm et (b) déshalogéner-hydrogéner le film formé; les étapes en séquence (a) et (b) étant répétées de nombreuses fois.

2. Méthode de la revendication 1 dans laquelle le film semi-conducteur du type silicium contenant un halogène, est un semi-conducteur de silicium amorphe halogéné et la déshalogénation-hydrogénation est effectuée par mise en contact du film semi-conducteur de silicium amorphe halogéné avec du silane gazeux.

3. Méthode de la revendication 2 dans laquelle la déshalogénation-hydrogénation est effectuée sous irradiation avec de la lumière.
